# EUROPEAN PATENT APPLICATION

(11) **EP 4 808 318 A2**
(43) Date of publication of application: **16.09.2026**
(21) Application number: 26195988.6
(22) Date of filing: 30.04.2025
(51) Int. Cl.: H10F 77/48

(54) **SOLAR CELL AND PHOTOVOLTAIC MODULE**

(30) Priority: 30.04.2024 CN 202410544099
(62) Document number(s) of the earlier application(s) in accordance with Art. 76 EPC: 25173482.8 / 4 646 070
(71) Applicant: Jinko Solar (Shangrao) Co., Ltd., Shangrao, Jiangxi 334100 (CN); ZHEJIANG JINKO SOLAR CO., LTD., Haining, Zhejiang 314416 (CN)
(72) Inventor: PAN, Qiangqiang, Shangrao, 334100 (CN); XU, Menglei, Shangrao, 334100 (CN); YANG, Jie, Shangrao, 334100 (CN); ZHANG, Xinyu, Shangrao, 334100 (CN)
(74) Representative: Rösler Rasch van der Heide & Partner

(57) **Abstract**

Solar cell and photovoltaic module. Solar cell includes: semiconductor substrate, first passivation layer, and second passivation layer. Semiconductor substrate includes front surface and back surface opposite to each other. Back surface of semiconductor substrate has alternated N-type conductive regions and P-type conductive regions. First passivation layer is disposed on side of P-type conductive region facing away from semiconductor substrate. Length of first passivation layer along first direction is greater than length of P-type conductive region along first direction. Second passivation layer is disposed on side of N-type conductive region facing away from semiconductor substrate. Length of second passivation layer along first direction is smaller than length of N-type conductive region along first direction, first direction is parallel to plane of semiconductor substrate. Solar cell improves light utilization rate on backlight side of solar cell while reducing parasitic absorption of solar cell, thereby improving photoelectric conversion efficiency of solar cell.

## Description

### TECHNICAL FIELD

The present disclosure relates to the field of photovoltaic technologies, and particularly, to a solar cell and a photovoltaic module.

### BACKGROUND

With the increasing energy crisis and environmental pollution, the demand for renewable energy by humans is growing. Solar energy has the advantages of safety, non-pollution, and not limited by geographical conditions, making it the most widely used and promising renewable energy source. Among various effective technologies for utilizing solar energy, photovoltaic power generation is undoubtedly one of the most promising directions. Among many new types of the solar cell, back contact solar cells, also known as interdigitated back contact (IBC) solar cells, belong to a type of back contact solar cell. The biggest feature of IBC solar cells is that both the emitter electrode and the base electrode are disposed on the back of the cell, thereby reducing light shielding. Compared with solar cells with obstructed light receiving surfaces, IBC cells have higher short-circuit current and photoelectric conversion efficiency.

IBC cells eliminate the losses caused by electrode grid line obstruction due to unobstructed front, achieving maximum utilization of incident photons. Correspondingly, an interdigital arrangement of p+ and n+ regions needs to be formed on the back of the cell, and a gap region needs to be formed between the p+ and n+ regions to separate them, in order to avoid short circuits in the cell. However, the existing IBC cell back structure has limited improvement in the photoelectric conversion efficiency of the cell. Prior documents include patent application CN 117334760 A.

Therefore, how to improve the photoelectric conversion efficiency of IBC cells is still a problem that needs to be solved.

### SUMMARY

The present disclosure provides a solar cell and a photovoltaic module that can improve the light utilization rate of the backlight side in solar cells while reducing parasitic absorption, thereby improving the photoelectric conversion efficiency of the solar cell. The invention is defined by the appended claims.

In the first aspect, the present disclosure provides a solar cell comprising:
a semiconductor substrate comprising a front surface and a back surface that are arranged opposite to each other, wherein the back surface of the semiconductor substrate has alternated N-type conductive regions and P-type conductive regions;
a first passivation layer disposed on a side of the P-type conductive region facing away from the semiconductor substrate, wherein a length of the first passivation layer along a first direction is greater than a length of the P-type conductive region along the first direction;
a second passivation layer disposed on a side of the N-type conductive region facing away from the semiconductor substrate, wherein a length of the second passivation layer along the first direction is smaller than a length of the N-type conductive region along the first direction, the first direction is parallel to the plane of the semiconductor substrate;
a first doping conductive layer disposed on a side of the first passivation layer facing away from the semiconductor substrate;
a second doping conductive layer disposed on a side of the second passivation layer facing away from the semiconductor substrate;
a first electrode forming ohmic contact with the first doping conductive layer; and
a second electrode forming ohmic contact with the second doping conductive layer.

In the second aspect, the embodiments of the present disclosure provide a photovoltaic module comprising a cover plate, an encapsulation material layer, and a solar cell string, wherein the solar cell string comprises multiple solar cells as described in the first aspect.

### BRIEF DESCRIPTION OF DRAWINGS

The following will further explain the present disclosure in conjunction with the accompanying drawings and embodiments.
FIG. 1 is a structural schematic diagram of a solar cell according to some embodiments of the present disclosure;
FIG. 2 shows a scanning electron microscope image of a P-type conductive region with a first passivation layer in the solar cell according to some embodiments of the present disclosure;
FIG. 3 is a scanning electron microscope image of an N-type conductive region with a second passivation layer in the solar cell according to some embodiments of the present disclosure;
FIG. 4 is a structural schematic diagram of a P-type conductive region with a first passivation layer in a solar cell according to some embodiments of the present disclosure;
FIG. 5 is a structural schematic diagram of an N-type conductive region with a second passivation layer in a solar cell according to some embodiments of the present disclosure;
FIG. 6 is another structural schematic diagram of a solar cell according to some embodiments of the present disclosure;
FIG. 7 is a flowchart of a preparation process of a solar cell according to some embodiments of the present disclosure;
FIG. 8 is a structural schematic diagram of a solar cell after forming N-type conductive regions and P-type conductive regions according to some embodiments of the present disclosure;
FIG. 9 is a structural schematic diagram of a solar cell after forming a first passivation layer and a second passivation layer according to some embodiments of the present disclosure;
FIG. 10 is a structural schematic diagram of a solar cell after forming a textured structure and a front passivation layer according to some embodiments of the present disclosure;
FIG. 11 is a structural schematic diagram of the solar cell after forming a first doping conductive layer and a second doping conductive layer according to some embodiments of the present disclosure;
FIG. 12 is a structural schematic diagram of the solar cell after forming a third passivation layer according to some embodiments of the present disclosure; and
FIG. 13 is a structural schematic diagram of a photovoltaic module according to some embodiments of the present disclosure.

### Reference signs:

1- semiconductor substrate;
2-n-type conductive region;
21- third surface;
22- fourth surface;
3-p-type conductive region;
31- first surface;
32- second surface;
4- isolation region;
5- first passivation layer;
6- second passivation layer;
7-first doping conductive layer;
8-second doping conductive layer;
9-third passivation layer;
10 textured structure;
11- front passivation layer;
12- first electrode;
13- second electrode;
14- first side surface;
15- second side surface;
1000- photovoltaic module;
100- solar cell;
200- first cover plate;
300- first encapsulation adhesive layer;
400- second encapsulation adhesive layer; and
500- second cover plate.

### DESCRIPTION OF EMBODIMENTS

In order to better understand technical solutions of the present disclosure, the embodiments of the present disclosure are described in details with reference to the drawings.

It should be clear that the described embodiments are merely part of the embodiments of the present disclosure rather than all of the embodiments. All other embodiments obtained by those skilled in the art without paying creative labor shall fall into the protection scope of the present disclosure.

The terms used in the embodiments of the present disclosure are merely for the purpose of describing specific embodiment, rather than limiting the present disclosure. The terms "a", "an", "the" and "said" in a singular form in the embodiments of the present disclosure and the attached claims are also intended to include plural forms thereof, unless noted otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

In the related art, the backside process of IBC cells involves the formation of p+ and n+ regions arranged in an interdigital shape through phosphorus diffusion and boron diffusion. In some embodiments, boron diffusion is first carried out on the back of the silicon substrate to form an n+ doping layer, and then a portion of the n+ doping layer is removed by local laser. Then, phosphorus diffusion is carried out in the area where the n+ doping layer is removed to form a p+ doping layer, and etching and acid washing are performed to form a gap region between the n+ doping layer and the p+ doping layer. The gap region is generally in the shape of a trench, which is used to prevent the recombination problem in the contact area between the n+ doping layer and the p+ doping layer. At present, by setting a passivation contact structure on the back of IBC cells, the rate of carrier recombination on the backlight side of IBC cells can be reduced, and the photoelectric conversion efficiency of IBC cells can be improved. The commonly used passivation structures include tunneling passivation contact structures and heterogeneous passivation contact structures. However, the existing passivation contact structures have low light utilization rate on the backlight side of IBC cells, and there is significant parasitic absorption in the passivation contact area, which is not conducive to improving the photoelectric conversion efficiency of the solar cell.

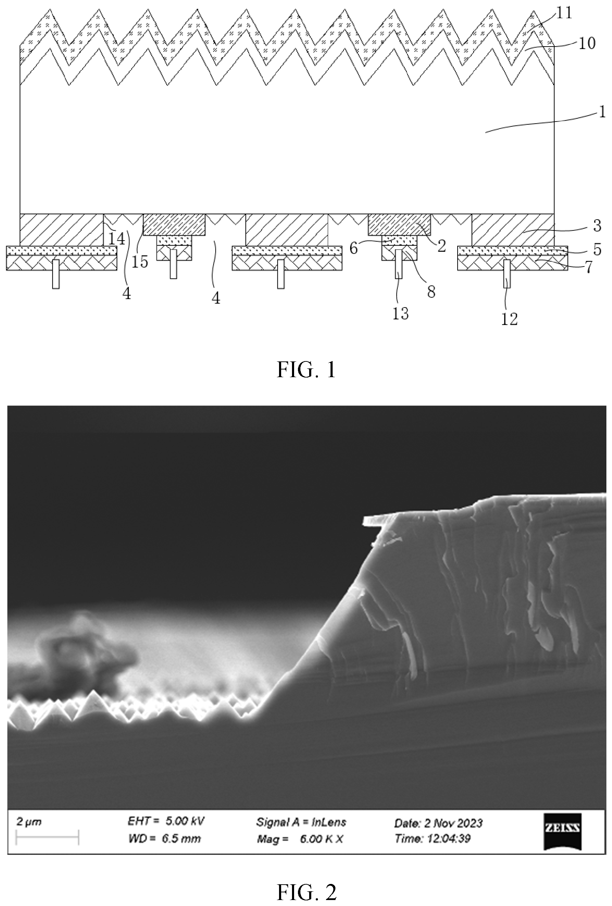

In view of this, the present disclosure provides a solar cell. Referring to FIG. 1 to FIG. 3, the solar cell includes a semiconductor substrate 1, a first passivation layer 5, a second passivation layer 6, a first doping conductive layer 7, a second doping conductive layer 8, a first electrode 12, and a second electrode 13.

The semiconductor substrate 1 includes a front surface and a back surface that are arranged opposite to each other. The back surface of semiconductor substrate 1 has alternated N-type conductive regions 2 and P-type conductive regions 3.

The first passivation layer 5 is disposed on a side of the P-type conductive region 3 facing away from the semiconductor substrate 1. A length of the first passivation layer 5 along the first direction is greater than that of the P-type conductive region 3 along the first direction.

The second passivation layer 6 is disposed on a side of the N-type conductive region 2 facing away from the semiconductor substrate 1. The length of the second passivation layer 6 along the first direction is smaller than the length of the N-type conductive region 2 along the first direction. The first direction is parallel to the plane of the semiconductor substrate 1.

The first doping conductive layer 7 is disposed on a side of the first passivation layer 5 facing away from the semiconductor substrate 1.

The second doping conductive layer 8 is disposed on a side of the second passivation layer 6 facing away from the semiconductor substrate 1.

The first electrode 12 forms ohmic contact with the first doping conductive layer 7.

The second electrode 13 forms ohmic contact with the second doping conductive layer 8.

In the above technical solutions, the back surface of the semiconductor substrate 1 has alternated N-type conductive regions 2 and P-type conductive regions 3, wherein the N-type conductive region 2 is doped with N-type elements, the P-type conductive region 3 is doped with P-type elements, the P-type conductive region 3 is provided with a first passivation layer 5 on the side facing away from the semiconductor substrate 2, and the first passivation layer 5 is provided with a first doping conductive layer 7 on the side facing away from the semiconductor substrate 1, which can form a first passivation contact structure in the P-type conductive region 3. The length of the first passivation layer 5 along the first direction is greater than the length of the P-type conductive region 3 along the first direction, which can increase the size of the first passivation contact structure, thereby increasing the reflection area of the first passivation contact structure in the P-type conductive region 3 for front incident light. The front incident light can be reflected multiple times back into the semiconductor substrate 1 and being absorbed and utilized by the semiconductor substrate 1. It can also increase the number of reflection of the reflected light on the back of the solar cell, improve the light utilization rate on the back side of the solar cell, and thus enhance the photoelectric conversion efficiency of the solar cell. The side of N-type conductive region 2 facing away from semiconductor substrate 1 is provided with a second passivation layer 6, and the side of second passivation layer 6 facing away from semiconductor substrate 1 is provided with a second doping conductive layer 8, which can form a second passivation contact structure in N-type conductive region 2. The length of second passivation layer 6 along the first direction is smaller than that of N-type conductive region 2 along the first direction, which can reduce the size of the second passivation contact structure in N-type conductive region 3, thereby reducing the parasitic absorption of light in the second passivation contact structure and improving the photoelectric conversion efficiency of the solar cell. In addition, the N-type conductive region 2 and the P-type conductive region 3 of the present disclosure are designed with passivation contact structures of different sizes, which can reduce the carrier recombination rate at the lateral boundary between the N-type conductive region 2 and the P-type conductive region 3, and also reduce the electrode contact resistance between the back first electrode 12 and the second electrode 13, further improving the photoelectric conversion efficiency of the solar cell. The present disclosure focuses on the size design of passivation contact structures in different areas of the back of the solar cell, which can improve the light utilization rate of the back of the solar cell, reduce parasitic absorption of the solar cell, and lower the recombination rate of carriers in different areas of the back of the solar cell, thereby improving the photoelectric conversion efficiency of the solar cell.

In the present disclosure, the P-type conductive region 3 refers to a region formed by highly doped P-type semiconductor material, while the N-type conductive region 2 refers to a region formed by highly doped N-type semiconductor material. The P-type conductive region 3 and N-type conductive region 2 are distributed in a interdigital pattern on the back surface of semiconductor substrate 1, mainly for separating and collecting carriers. The P-type conductive region 3 is used to collect holes, the N-type conductive region 2 is used to collect electrons, and then the collected carriers are transferred to the back surface electrode of semiconductor substrate 1 and to form a path with external load. Therefore, the P-type conductive region 3 and N-type conductive region 2 cannot directly contact each other, otherwise the collected carriers will directly contact and form a short circuit on the back surface of the semiconductor substrate 1, resulting in ineffective collection of carriers. Therefore, a "groove shaped" isolation region 4 is usually formed in P-type conductive region 3 and N-type conductive region 2.

It should be noted that the semiconductor substrate 1 generally has a front surface and a back surface. The front surface of semiconductor substrate 1 can refer to the light receiving surface, i.e., a surface that receives sunlight, while the back surface of semiconductor substrate 1 refers to a surface opposite to the front surface.

In some embodiments, the semiconductor substrate 1 is an N-type crystalline silicon substrate (or silicon wafer), and may also be a P-type crystalline silicon substrate (silicon wafer). A crystalline silicon substrate (silicon substrate) can be e.g., a polycrystalline silicon substrate, a monocrystalline silicon substrate, a microcrystalline silicon substrate, or a silicon carbide substrate, which is not limited to the type of the semiconductor substrate 1 in the embodiments of the present disclosure. When the semiconductor substrate 1 is an N-type substrate, doping elements can be V group elements such as phosphorus (P), arsenic (As), tellurium (Te), etc. The N-type semiconductor substrate 1 forms a PN junction with P-type conductive region 3, and the N-type semiconductor substrate 1 and the N-type conductive region 2 form an NN+ high-low junction. When the semiconductor substrate 1 is a P-type substrate, the doping element can be group III elements such as boron (B), aluminum (Al), gallium (Ga), etc. The P-type semiconductor substrate 1 forms a PN junction with N-type conductive region 2, and the P-type semiconductor substrate 1 and P-type conductive region 3 form a PP+ high-low junction.

In some embodiments, the thickness of the semiconductor substrate 1 is between 60 µm and 240 µm, which can be 60 µm, 80 µm, 90 µm, 100 µm, 120 µm, 150 µm, 200 µm, or 240 µm, which is not limited here.

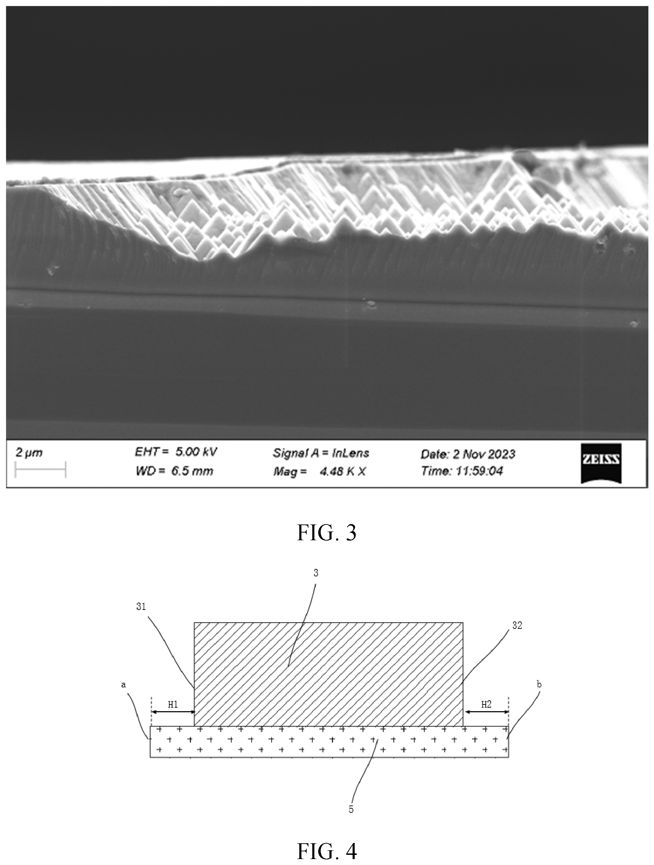

In some embodiments, FIG. 4 is a structural schematic diagram of a P-type conductive region with a first passivation layer 5 in a solar cell. Referring to FIG. 4, the P-type conductive region 3 includes a first surface 31 and a second surface 32 that are arranged opposite to each other. At least a part of the first passivation layer 5 includes a first passivation sub-surface a and a first passivation sub-surface b that are arranged opposite to each other. The first surface 31, the second surface 32, the first passivation sub-surface a, and the first passivation sub-surface b are all perpendicular to the first direction. The first passivation sub-surface a protrudes relative to the first surface 31, and/or the first passivation sub-surface b protrudes relative to the second surface 32, so that the size of the first passivation contact structure in the P-type conductive region 3 can be increased, the reflection area of the first passivation contact structure in the P-type conductive region 3 for the front incident light can be increased, the front incident light can be reflected back into the semiconductor substrate 1 and be absorbed and utilized by the semiconductor substrate 1, the number of reflections of the reflected light on the back side of the solar cell can be increased, thereby improving the utilization rate of light on the back side of the solar cell, and thus improving the photoelectric conversion efficiency of the solar cell.

In some embodiments, referring to FIG. 4, the distance between the first passivation sub-surface a and the first surface 31 is H1, H1=1µm to 300µm, e.g., it can be 1 µm, 5 µm, 10 µm, 20 µm, 50 µm, 100 µm, 150 µm, 200 µm, 250 µm, or 300 µm, etc. Of course, it can also be other values within the above range, which are not limited here. If the distance between the first passivation surface a and the first surface 31 is smaller than 1 µm, the first passivation contact structure in the P-type conductive region 3 has a smaller reflection area for the front incident light, which is not conducive to increasing the light utilization rate of the back of the solar cell. If the distance between the first passivation surface a and the first surface 31 is greater than 300 µm, it increases the recombination efficiency of carriers in the P-type conductive region 3 and the N-type conductive region 2, which is not conducive to improving the photoelectric conversion efficiency of the solar cell. In some embodiments, the distance between the first passivation sub-surface a and the first surface 31 is 50 µm to 200 µm.

In some embodiments, referring to FIG. 4, the distance between the first passivation sub-surface b and the second surface 32 is H2, H2=1µm to 300µm, e.g., it can be 1 µm, 5 µm, 10 µm, 20 µm, 50 µm, 100 µm, 150 µm, 200 µm, 250 µm, or 300 µm, etc. Of course, it can also be other values within the above range, which are not limited here. If the distance between the first passivation surface b and the second surface 32 is smaller than 1 µm, the first passivation contact structure formed by the first passivation layer 5 and the first doping conductive layer 7 in the P-type conductive region 3 has a smaller reflection area for the front incident light, which is not conducive to increasing the light utilization rate of the back of the solar cell. If the distance between the first passivation surface b and the second surface 32 is greater than 300 µm, it increases the recombination efficiency of carriers in the P-type conductive region 3 and the N-type conductive region 2, which is not conducive to improving the photoelectric conversion efficiency of the solar cell. In some embodiments, the distance between the first passivation surface b and the second surface 32 is 50 µm to 200 µm.

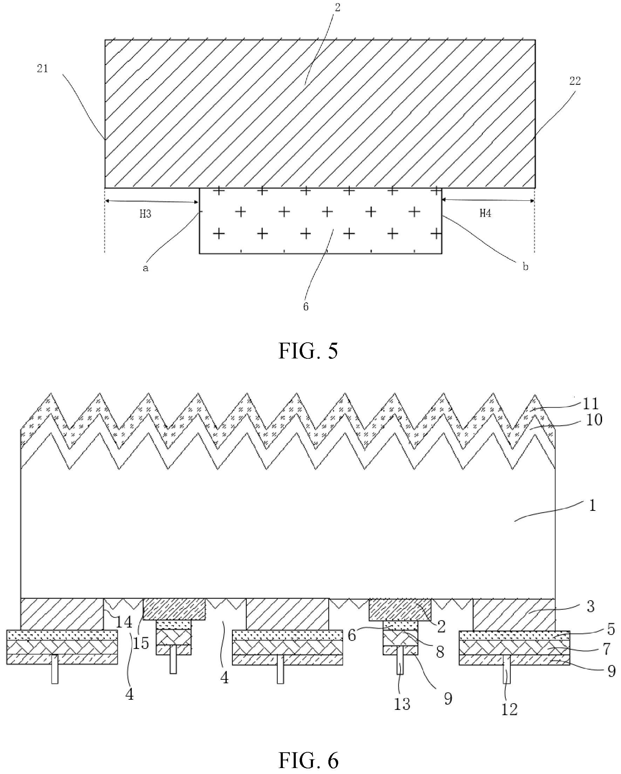

In some embodiments, FIG. 5 is a structural schematic diagram of an N-type conductive region with a second passivation layer in a solar cell. Referring to FIG. 5, the N-type conductive region 2 includes a third surface 21 and a fourth surface 22 that are arranged opposite to each other, and the second passivation layer 6 includes a second passivation sub-surface a and a second passivation sub-surface b that are arranged opposite to each other. The third surface 21 and the fourth surface 22, the second passivation sub-surface a and the second passivation sub-surface b are all perpendicular to the first direction. The second passivation sub-surface a is recessed relative to the third surface 21, and/or the second passivation sub-surface b is recessed relative to the fourth surface 22, which can reduce the size of the second passivation contact structure, reduce parasitic absorption of light in the solar cell, reduce light loss, and improve the photoelectric conversion efficiency of the solar cell.

In some embodiments, referring to FIG. 5, the distance between the second passivation sub-surface a and the third surface 21 is H3, H3=1µm to 100µm, e.g., it can be 1 µm, 5 µm, 10 µm, 20 µm, 50 µm, 60 µm, 70 µm, 81 µm, 90 µm, or 100 µm, etc. Of course, it can also be other values within the above range, which is not limited here. If the distance between the second passivation sub-surface a and the third surface 21 is smaller than 1 µm, the area of the second doping conductive layer 8 in the N-type conductive region is large, which increases the parasitic absorption of light in the N-type conductive region and is not conducive to improving the photoelectric conversion efficiency of the solar cell. If the distance between the second passivation sub-surface a and the third surface 21 is greater than 100 µm, the size of the second passivation contact formed by the second passivation layer 6 and the second doping conductive layer 8 in the N-type conductive region 2 is too small, and the ohmic contact resistance formed by the second electrode 13 and the second doping conductive layer 8 increases, which limits the transfer of carriers from the N-type conductive region 2 to the second electrode 13 and is not conducive to improving the photoelectric conversion efficiency of the solar cell. In addition, it will also block more light emitting area, resulting in a reduction in the effective absorption area of light, which is not conducive to improving the photoelectric conversion efficiency of the solar cell. Meanwhile, it is also not conducive to reducing the recombination of carriers in the N-type conductive region 2, which affects the passivation effect of the solar cell. In some embodiments, the distance between the second passivation sub-surface a and the third surface 21 is 50 µm to 100 µm.

In some embodiments, referring to FIG. 5, where the distance between the second passivation sub-surface b and the fourth surface 22 is H4, H4=1µm to 100µm, e.g., it can be 1 µm, 5 µm, 10 µm, 20 µm, 50 µm, 60 µm, 70 µm, 80 µm, 90 µm, or 100 µm, etc. Of course, it can also be other values within the above range, which is not limited here. If the distance between the second passivation sub-surface a and the fourth surface 22 is smaller than 1 µm, the area of the second doping conductive layer 8 in the N-type conductive region is large, which increases the parasitic absorption of light in the N-type conductive region and is not conducive to improving the photoelectric conversion efficiency of the solar cell. If the distance between the second passivation sub-surface b and the fourth surface 22 is greater than 100 µm, the size of the second passivation contact formed by the second passivation layer 6 and the second doping conductive layer 8 in the N-type conductive region 2 is too small, and the ohmic contact resistance formed by the second electrode 13 and the second doping conductive layer 8 increases, which limits the transfer of carriers from the N-type conductive region 2 to the second electrode 13 and is not conducive to improving the photoelectric conversion efficiency of the solar cell. In addition, it will also block more light emitting area, resulting in a reduction in the effective absorption area of light, which is not conducive to improving the photoelectric conversion efficiency of the solar cell. Meanwhile, it is also not conducive to reducing the recombination of carriers in the N-type conductive region 2, which affects the passivation effect of the solar cell. In some embodiments, the distance between the second passivation sub-surface b and the fourth surface 22 is 50 µm to 100 µm.

In some embodiments, the first passivation layer 5 and the second passivation layer 6 are tunneling layers, and the materials of the first passivation layer 5 and the second passivation layer 6 include, but are not limited to, a dielectric material with tunneling effect such as silicon oxide, silicon nitride, silicon oxynitride, intrinsic amorphous silicon, and intrinsic polycrystalline silicon.

In some embodiments, the thickness of the first passivation layer 5 is 1nm to 5nm, which can be 1nm, 2nm, 2.6nm, 3nm, 3.5nm, 4nm, or 5nm, etc. Of course, it can also be other values within the above range, which is not limited here.

In some embodiments, the thickness of the second passivation layer 6 is 1nm to 5nm, which can be 1nm, 2nm, 2.6nm, 3nm, 3.5nm, 4nm, or 5nm, etc. Of course, it can also be other values within the above range, which is not limited here.

In some embodiments, the surface of the P-type conductive region 3 facing away from the semiconductor substrate 1 is a smooth surface, which can improve the reflectivity of light in the P-type conductive region 3, enhance the passivation effect of the solar cell, reduce the recombination rate of carriers in the P-type conductive region 3, and thus improve the photoelectric conversion efficiency of the solar cell.

In some embodiments, the surface of the N-type conductive region 2 facing away from the semiconductor substrate 1 is a rough surface, which can increase the scattering and capture of light in the N-type conductive region 2, reduce light loss, and improve the light absorption efficiency of the solar cell.

In some embodiments, referring to FIG. 1, the solar cell further comprises an isolation region 4 disposed between the N-type conductive region 2 and the P-type conductive region 3. A first side surface 14 is disposed between the isolation region 4 and the P-type conductive region 3. The first side surface 14 is a smooth surface, which can improve the reflectivity of light on the back of the solar cell, thereby enhancing the photoelectric conversion efficiency of the solar cell.

In some embodiments, the solar cell further comprises an isolation region 4 disposed between the N-type conductive region 2 and the P-type conductive region 3. A second side surface 15 is disposed between the isolation region 4 and the N-type conductive region 2. The second side surface 15 is a rough surface, which can increase the scattering and capture of light in the N-type conductive region 2, reduce light loss, and improve the light absorption efficiency of the solar cell.

In some embodiments, referring to FIG. 1. The isolation region 4 hasa textured structure, which can effectively reduce the reflectivity of the surface of the semiconductor substrate 1, increase light absorption, and thus improve the photoelectric conversion efficiency of the cell.

In some embodiments, the width of isolation region 4 is between 1 µm and 300 µm, which can be 1 µm, 5 µm, 10 µm, 50 µm, 100 µm, 150 µm, 200 µm, 250 µm, or 300 µm, among others. Of course, other values within the above range are also possible and are not limited here. It can be understood that the width of isolation region 4 within the above range is beneficial for reducing the recombination rate of carriers in N-type conductive region 2 and P-type conductive region 3, and improving the photoelectric conversion efficiency of the solar cell.

In some embodiments, the projection of the first passivation layer 5 on the surface of the semiconductor substrate 1 at least partially overlaps the projection of the first side surface 14 on the surface of the semiconductor substrate 1.

In some embodiments, an area of the overlapping area between the projection of the first passivation layer 5 on the surface of the semiconductor substrate 1 and the projection of the first side surface 14 on the surface of the semiconductor substrate 1 is denoted as S1, and an area of projection of the first side surface 14 on the surface of the semiconductor substrate 1 is denoted as S2, S1/S2=(0.2 to 0.99): 1. In some embodiments, it can be 0.2:1, 0.3:1, 0.5:1, 0.6:1, 0.8:1, 0.9:1, or 0.99:1, etc. Of course, it can also be other values within the above range, which are not limited here. S1/S2 can ensure that the length of the first passivation layer 5 in the first direction is greater than the length of the P-type conductive region 3 along the first direction within the above-mentioned limited range, thereby increasing the reflection area of the first passivation contact structure formed in the P-type conductive region 3 for the front incident light, improving the light utilization rate of the back of the solar cell, and enhancing the photoelectric conversion efficiency of the solar cell.

In some embodiments, the area of the projection of the second passivation layer 6 on the surface of the semiconductor substrate 1 is denoted as S3, and the area of the projection of the N-type conductive region 2 on the surface of the semiconductor substrate 1 is denoted as S4, S3/S4=(1.01to1.90): 1. In some embodiments, it can be 1.01:1, 1.1:1, 1.3:1, 1.5:1, 1.6:1, 1.8:1, or 1.9:1, etc. Of course, it can also be other values within the above range, which are not limited here. S3/S4 can ensure that the length of the second passivation layer 6 along the first direction is smaller than the length of the N-type conductive region 2 along the first direction within the above-mentioned limited range, thereby reducing parasitic absorption of light in the solar cell and improving the photoelectric conversion efficiency of the solar cell.

In some embodiments, the thickness of the first doping conductive layer 7 is greater than or equal to the thickness of the second doping conductive layer 8, which can improve the passivation effect on the back of the solar cell, reduce the recombination rate of carriers in the solar cell, and also reduce parasitic absorption of light in the solar cell, thereby improving the photoelectric conversion efficiency of the solar cell.

In some embodiments, the thickness of the first doping conductive layer 7 is between 50 nm and 500 nm, which can be 50 nm, 100 nm, 150 nm, 200 nm, 300 nm, 350 nm, 400 nm, or 500 nm, etc. Of course, other values within the above range are also possible and are not limited here.

In some embodiments, the thickness of the second doping conductive layer 8 is between 50 nm and 300 nm, which can be 50 nm, 100 nm, 150 nm, 180 nm, 200 nm, 240 nm, 280 nm, or 300 nm. Of course, other values within the above range are also possible and are not limited here.

In some embodiments, referring to FIG. 1, the length of the first doping conductive layer 7 along the first direction is greater than the length of the P-type conductive region 3 along the first direction. This can increase the size of the first passivation contact structure in the P-type conductive region 3, increase the reflection area of the front incident light, and improve the light utilization rate of the back of the solar cell.

In some embodiments, the material of the first doping conductive layer 7 includes a semiconductor material such as polycrystalline silicon, microcrystalline silicon, and silicon carbide, and the doping element in the first doping conductive layer 7 includes at least one of boron (B), aluminum (Al), and gallium (Ga).

In some embodiments, the length of the second doping conductive layer 8 along the first direction is smaller than the length of the N-type conductive region 2 along the first direction, which can reduce the area of the second doping conductive layer 8 in the N-type conductive region 2, reduce parasitic absorption of the solar cell, and thus improve the photoelectric conversion efficiency of the solar cell.

In some embodiments, the material of the second doping conductive layer 8 includes a semiconductor material such as polycrystalline silicon, microcrystalline silicon, and silicon carbide, and the doping element in the second doping conductive layer 8 includes at least one of phosphorus (P), arsenic (As), and tellurium (Te).

In some embodiments, referring to FIG. 1, the solar cell further comprises a textured structure 10 provided on the front surface of the semiconductor substrate 1 and a front passivation layer 11 provided on the surface of the textured structure 10. It can be understood that by setting a textured structure 10 on the front surface of the semiconductor substrate 1, the reflection of sunlight on the front surface of the semiconductor substrate 1 can be reduced, the absorption rate of sunlight on the front surface of the semiconductor substrate 1 can be increased, and thus the photoelectric conversion efficiency of the solar cell can be improved.

In some embodiments, the front passivation layer 11 may include, but is not limited to, a single-layer oxide layer or a multi-layer structure such as silicon oxide, silicon nitride, silicon oxynitride, aluminum oxide, etc. Of course, other types of passivation layers can also be used. The material of the front passivation layer 11 is not limited by the present disclosure. The above front passivation layer 11 can produce good passivation and anti-reflection effect on the semiconductor substrate 1, which helps to improve the conversion efficiency of the cell.

In some embodiments, FIG. 6 is another structural schematic diagram of the solar cell provided in the present disclosure. Referring to FIG. 6. The solar cell further includes a third passivation layer 9, which covers the first doping conductive layer 7 and the second doping conductive layer 8.

In some embodiments, the third passivation layer 9 comprises a combination of any one or more of a silicon nitride layer, a silicon nitride oxide layer, or an aluminum oxide/silicon nitride laminated structure. Of course, other types of passivation layers can also be used for the third passivation layer 9. The material of the third passivation layer 9 is not limited in the present disclosure. For example, in other embodiments, the third passivation layer 9 can also be laminated silicon dioxide and silicon nitride. The third passivation layer 9 mentioned above can produce a good passivation effect on the semiconductor substrate 1, which helps to improve the conversion efficiency of the cell.

In some embodiments, referring to FIG. 6, and a first electrode 12 is provided on the surface of the third passivation layer 9 to form ohmic contact with the first doping conductive layer 7. A second electrode 13 is provided on the surface of the third passivation layer 9 to form ohmic contact with the second doping conductive layer 8.

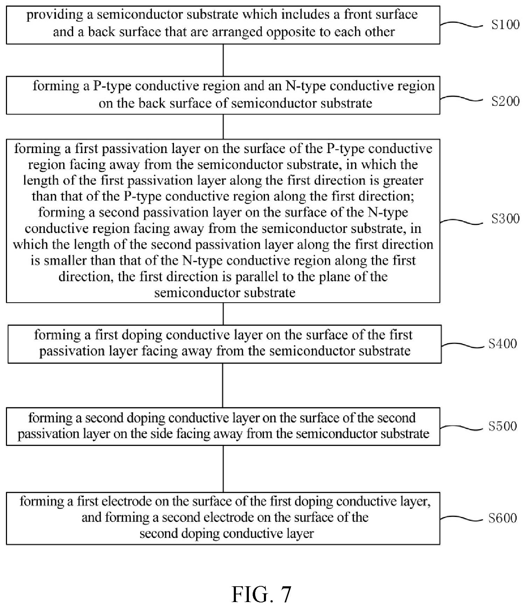

The present disclosure also provides a method for preparing the solar cell mentioned above. FIG. 7 shows a preparation process of the solar cell according to some embodiments of the present disclosure. As shown in FIG. 7, a method for preparing the solar cell includes the following steps:
providing a semiconductor substrate 1 which includes a front surface and a back surface that are arranged opposite to each other;
forming an N-type conductive region 2 and a P-type conductive region 3 on the back surface of semiconductor substrate 1;
forming a first passivation layer 5 on the surface of P-type conductive region 3 facing away from semiconductor substrate 1, in which the length of the first passivation layer 5 along the first direction is greater than that of P-type conductive region 3 along the first direction; forming a second passivation layer 6 on the surface of N-type conductive region 2 facing away from semiconductor substrate 1, in which the length of the second passivation layer 6 along the first direction is smaller than that of N-type conductive region 2 along the first direction which is parallel to the plane of the semiconductor substrate;
forming a first doping conductive layer 7 on the surface of the first passivation layer 5 facing away from the semiconductor substrate 1;
forming a second doping conductive layer 8 on the surface of the second passivation layer on the side 6 facing away from the semiconductor substrate 1;
forming a first electrode 12 on the surface of the first doping conductive layer 7, and forming a second electrode 13 on the surface of the second doping conductive layer 8.

Step S100: providing a semiconductor substrate 1 which includes a front surface and a back surface that are arranged opposite to each other.

In some embodiments, the front surface of semiconductor substrate 1 corresponds to the front surface of the cell, which is the surface facing the sun (i.e. the light receiving surface), and the back surface of semiconductor substrate 1 corresponds to the back surface of the cell, which is the surface facing away from the sun (i.e. the back surface).

In some embodiments, semiconductor substrate 1 is an N-type crystalline silicon substrate (or silicon wafer), and may also be a P-type crystalline silicon substrate (silicon wafer). A crystalline silicon substrate (silicon substrate), such as a polycrystalline silicon substrate, a monocrystalline silicon substrate, a microcrystalline silicon substrate, or a silicon carbide substrate, is not limited to the type of semiconductor substrate 1 in the embodiments of the present disclosure.

In some embodiments, the thickness of the semiconductor substrate 1 is between 60 µm and 240 µm, which can be 60 µm, 80 µm, 90 µm, 100 µm, 120 µm, 150 µm, 200 µm, or 240 µm, which is not limited here.

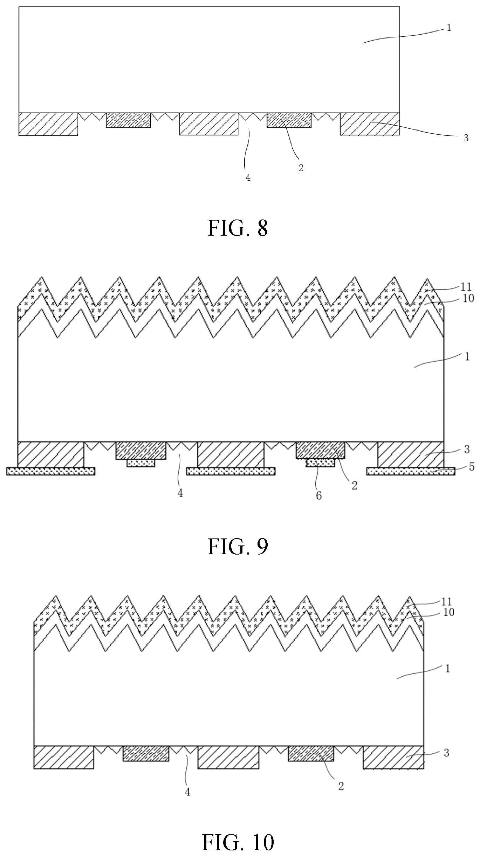

Step S200: forming a P-type conductive region 3 and an N-type conductive region 2 on the back surface of semiconductor substrate 1, and the obtained structure is shown in FIG. 8.

In this step, diffusion treatment is performed on the back surface of semiconductor substrate 1 to prepare N-type conductive regions 2 and P-type conductive regions 3 alternately arranged on the back surface of semiconductor substrate 1. The process of the diffusion treatment mentioned above is not limited in the present disclosure.

In some embodiments, after step S200, it further includes polishing the surface of the side of the P-type conductive region 3 facing away from the semiconductor substrate 1 to obtain a P-type conductive region 3 with a smooth surface.

In some embodiments, after step S200, it further includes a texturing treatment on the surface of the side of the N-type conductive region 2 facing away from the semiconductor substrate 1 to obtain the N-type conductive region 2 with a rough surface.

Step S300: forming a first passivation layer 5 on the surface of the P-type conductive region 3 facing away from the semiconductor substrate 1, in which the length of the first passivation layer 5 along the first direction is greater than that of the P-type conductive region 3 along the first direction; forming a second passivation layer 6 on the surface of the N-type conductive region 2 facing away from the semiconductor substrate 1, in which the length of the second passivation layer 6 along the first direction is smaller than that of the N-type conductive region 2 along the first direction. The obtained structure is shown in FIG. 9. The first direction is parallel to the plane of the semiconductor substrate.

In some embodiments, before step S300, the method for preparing the solar cell of the present disclosure further comprises: forming a texturing structure 10 on the front surface of the semiconductor substrate 1 through texturing treatment, and forming a front passivation layer 11 on the surface of the texturing structure 10, as shown in FIG. 10.

As shown in FIG. 10, the present disclosure forms a pyramid shaped texturing structure 10 by performing texturing treatment on the front surface of the semiconductor substrate 1, which can reduce the reflection of sunlight on the front surface of the semiconductor substrate 1, improve the absorption rate of sunlight on the front surface of the semiconductor substrate 1, and thus enhance the photoelectric conversion efficiency of the solar cell.

In some embodiments, the front passivation layer 11 may include, but is not limited to, a single-layer oxide layer or a multi-layer structure such as silicon oxide, silicon nitride, silicon oxynitride, aluminum oxide, etc. Of course, other types of passivation layers can also be used. The material of the front passivation layer 11 is not limited by the present disclosure. The above front passivation layer 11 can produce good passivation and anti-reflection effect on the semiconductor substrate 1, which helps to improve the conversion efficiency of the cell.

In some embodiments, the thickness range of the front passivation layer 11 is 40nm to 100nm, which can be 40nm, 50nm, 60nm, 70nm, 80nm, 90nm, or 100nm, etc. Of course, other values within the above range are also possible and are not limited here.

In some embodiments, the method for preparing the solar cell of the present disclosure further comprises forming an anti-reflection layer (structure not shown in the drawing) on the surface of the front passivation layer 11 to reduce light reflection on the front surface of the cell.

In some embodiments, the anti-reflection layer can be, for example, a silicon nitride layer or an aluminum oxide/silicon nitride laminated structure, which is not limited in the present disclosure. Taking the silicon nitride oxide layer as an example, the presence of silicon nitride oxide can effectively reduce light reflection and improve transmittance. By controlling the thickness of the film, its reflectivity can be adjusted to achieve the desired anti-reflection effect. Moreover, NH4, the raw material of silicon nitride oxide, will decompose into H atoms during the reaction process. H atoms will penetrate into the semiconductor substrate 1 at high temperatures and combine with the dangling bonds on the surface to have a passivation effect. In some embodiments, the first passivation layer 5 and the second passivation layer 6 are tunneling layers, and the materials of the first passivation layer 5 and the second passivation layer 6 include, but are not limited to, dielectric materials with tunneling effect, such as silicon oxide, silicon nitride, silicon oxynitride, intrinsic amorphous silicon, and intrinsic polycrystalline silicon.

In some embodiments, any one of ozone oxidation, high-temperature thermal oxidation, and nitric acid oxidation can be used to oxidize the surface of the P-type conductive region 3 and the N-type conductive region 2 on the side facing away from the semiconductor substrate 1, to obtain the first passivation layer 5 and the second passivation layer 6.

In some embodiments, the thickness of the first passivation layer 5 is 1 nm to 5 nm, which can be 1 nm, 2 nm, 2.6 nm, 3 nm, 3.5 nm, 4 nm, or 5 nm, etc. Of course, it can also be other values within the above range, which is not limited here.

In some embodiments, the thickness of the second passivation layer 6 is 1nm to 5nm, which can be 1nm, 2nm, 2.6nm, 3nm, 3.5nm, 4nm, or 5nm, etc. Of course, it can also be other values within the above range, which is not limited here.

Step S400: forming a first doping conductive layer 7 on the surface of the first passivation layer 5 facing away from the semiconductor substrate 1.

In some embodiments, the material of the first doping conductive layer 7 includes a semiconductor material such as polycrystalline silicon, microcrystalline silicon, and silicon carbide, and the doping elements in the first doping conductive layer 7 include at least one of boron (B), aluminum (Al), and gallium (Ga).

In some embodiments, the thickness range of the first doping conductive layer 7 is 50nm to 300nm, which can be 50nm, 60 nm, 100 nm, 150 nm, 180 nm, 200 nm, 250 nm, or 300 nm, etc. Of course, other values within the above range are also possible and are not limited here.

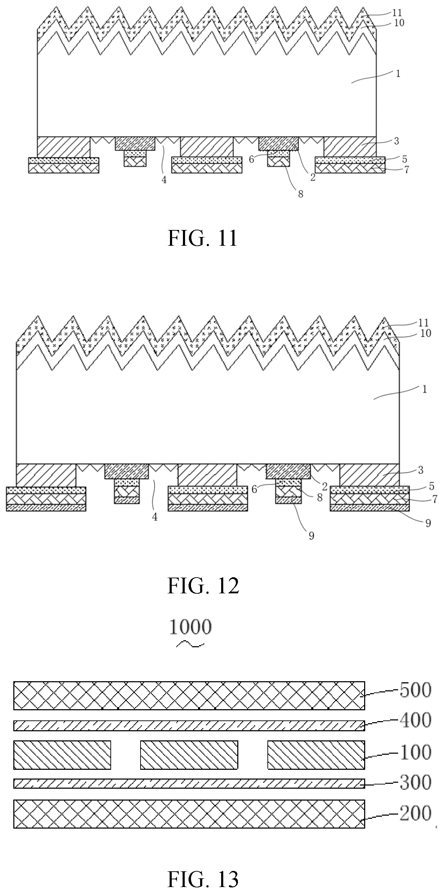

Step S500: forming a second doping conductive layer 8 on the surface of the second passivation layer 6 on the side facing away from the semiconductor substrate 1. The obtained structure is shown in FIG. 11.

In some embodiments, the material of the second doping conductive layer 8 includes a semiconductor material such as polycrystalline silicon, microcrystalline silicon, and silicon carbide, and the doping element in the second doping conductive layer 8 includes at least one of phosphorus (P), arsenic (As), and tellurium (Te).

In some embodiments, the thickness range of the second doping conductive layer 8 is 50nm to 500nm, which can be 50nm, 100nm, 150nm, 200nm, 300nm, 350nm, 400nm, or 500 nm, etc. Of course, other values within the above range are also possible and are not limited here.

In some embodiments, the method for manufacturing the solar cell further comprises: forming a third passivation layer 9 on the surfaces of the first doping conductive layer 7 and the second doping conductive layer 8, and the third passivation layer 9 covering the first doping conductive layer 7 and the second doping conductive layer 8, resulting in a structure as shown in FIG. 12.

In some embodiments, the third passivation layer 9 comprises a combination of any one or more of a silicon nitride layer, a silicon nitride oxide layer, or an aluminum oxide/silicon nitride laminated structure. Of course, other types of passivation layers can also be used for the third passivation layer 9. The material of the third passivation layer 9 is not limited in the present disclosure. For example, in other embodiments, the third passivation layer 9 can also be laminated silicon dioxide and silicon nitride. The third passivation layer 9 mentioned above can produce a good passivation effect on the semiconductor substrate 1, which helps to improve the conversion efficiency of the cell.

In some embodiments, plasma enhanced chemical vapor deposition can be used to deposit the third passivation layer 9, although other methods such as organic chemical vapor deposition can also be used.

In some embodiments, the thickness range of the third passivation layer 9 is 10 nm to 100 nm, which can be 10 nm, 20 nm, 30 nm, 42 nm, 50 nm, 60 nm, 70 nm, 80 nm, 90 nm, or 100 nm, etc. Of course, it can also be other values within the above range, which is not limited here.

Step S600, forming a first electrode 12 on the surface of the first doping conductive layer 7, and forming a second electrode 13 on the surface of the second doping conductive layer 8 to obtain a solar cell. The structural schematic diagram of the solar cell is shown in FIG. 1.

In some embodiments, in this step, by performing metalization treatment on the surfaces of the first doping conductive layer 7 and the second doping conductive layer 8, the first electrode 12 is obtained on the surface of the first doping conductive layer 7, and the second electrode 13 is obtained on the surface of the second doping conductive layer 8. The first electrode 12 and the second electrode 13 correspond to the P-type conductive region 3 and the N-type conductive region 2, respectively. The first electrode 12 and the second electrode 13 can be prepared by screen printing and sintered to form ohmic contact between the first electrode 12 and the N-type conductive region 2, and form ohmic contact between the second electrode 13 and the P-type conductive region 3. In some embodiments, the first electrode 12 can form ohmic contact with the P-type conductive region 3, and the second electrode 13 can form ohmic contact with the N-type conductive region 2. Of course, the first electrode 12 and the second electrode 13 can be formed on the back surface of the cell by means of at least one of metal vapor deposition and electroplating.

It should be noted that the materials of the first electrode 12 and the second electrode 13 are not limited in the embodiments of the present disclosure. For example, when the first electrode 12 forms ohmic contact with the P-type conductive region 3 and the second electrode 13 forms ohmic contact with the N-type conductive region 2, the first electrode 12 is a silver electrode or a silver/aluminum electrode, and the second electrode 13 is a silver electrode. For example, silver paste can be printed on the lower surface of the third passivation layer 9 corresponding to the N-type conductive region 2, and silver paste or silver/aluminum paste doped with a small amount of aluminum can be printed on the lower surface of the third passivation layer 9 corresponding to the P-type conductive region 3. By sintering, each paste can be burned through the third passivation layer 9, and the formed silver electrode or silver/aluminum electrode can form ohmic contact with the P-type conductive region 3, and the formed silver electrode can form ohmic contact with the N-type conductive region 24.

It should be noted that in the present disclosure, unless otherwise specified, each operational step can be performed sequentially or not. The present disclosure does not limit the sequence of steps for preparing the solar cell and can be adjusted according to the actual production process.

The present disclosure provides a photovoltaic module 1000, comprising electrically connected cell strings of the solar cell as described above.

In some embodiments, referring to FIG. 12, the photovoltaic module 1000 includes a first cover plate 200, a first encapsulation adhesive layer 300, a solar cell string, a second encapsulation adhesive layer 400, and a second cover plate 500.

In some embodiments, the solar cell string includes multiple solar cells 100 connected by conductive strips as described above, and the connection manner between the solar cells 100 can be partially laminated or spliced.

In some embodiments, the first cover plate 200 and the second cover plate 500 may be transparent or opaque cover plates, such as glass cover plates or plastic cover plates.

The two sides of the first encapsulation adhesive layer 300 are respectively in contact and adhered to the first cover plate 200 and the cell string, and the two sides of the second encapsulation adhesive layer 400 are respectively in contact and adhered to the second cover plate 500 and the cell string. The first encapsulation layer 300 and the second encapsulation layer 400 can be ethylene-vinyl acetate copolymer (EVA) film, polyethylene octene elastomer (POE) film, or polyethylene terephthalate (PET) film, respectively.

The photovoltaic module 1000 can also be packaged in a side enclosed manner, that is, the side of the photovoltaic module 1000 is completely encapsulated with packaging tape to prevent the phenomenon of lamination offset during the lamination process of the photovoltaic module 1000.

The photovoltaic module 1000 further includes an edge sealing component that is fixedly encapsulated on a portion of the edge of the photovoltaic module 1000. The edge sealing component can be fixedly encapsulated on the edge near the corner of the photovoltaic module 1000. The edge sealing component can be made of high-temperature resistant tape. This high-temperature resistant tape has excellent high-temperature resistance characteristics and will not decompose or fall off during the lamination process, ensuring reliable packaging of the photovoltaic module 1000. Two ends of the high-temperature resistant tape are respectively fixed to the second cover plate 500 and the first cover plate 200. The two ends of the high-temperature resistant adhesive tape can be respectively bonded to the second cover plate 500 and the first cover plate 200, while the middle part can achieve the limit of the side of the photovoltaic module 1000, preventing the photovoltaic module 1000 from being lamination offset during the lamination process.

## Claims

1. A solar cell (100), comprising: a semiconductor substrate (1) comprising a front surface and a back surface that are arranged opposite to each other, wherein the back surface of the semiconductor substrate has N-type conductive regions (2) and P-type conductive regions (3) that are alternately arranged; a first silicon oxide layer (5) and a first doping conductive layer (7) sequentially disposed on a side of the P-type conductive region (3) facing away from the semiconductor substrate (1), wherein a length of the first doping conductive layer (7) along a first direction is greater than a length of the P-type conductive region (3) along the first direction; a second silicon oxide layer (6) and a second doping conductive layer (8) sequentially disposed on a side of the N-type conductive region (2) facing away from the semiconductor substrate (1), wherein a length of the second doping conductive layer (8) along the first direction is smaller than a length of the N-type conductive region (2) along the first direction, and the first direction is parallel to a main plane of the semiconductor substrate (1);
a first electrode (12) forming ohmic contact with the first doping conductive layer (7); and a second electrode (13) forming ohmic contact with the second doping conductive layer (8).

2. The solar cell according to claim 1, wherein the P-type conductive region comprises a first surface and a second surface that are arranged opposite to each other, and at least part of the first silicon oxide layer comprises a first silicon oxide sub-surface a and a first silicon oxide sub-surface b that are arranged opposite to each other; and the first surface, the second surface, the first silicon oxide sub-surface a, and the first silicon oxide sub-surface b are all perpendicular to the first direction; wherein the first silicon oxide sub-surface a protrudes relative to the first surface.

3. The solar cell (100) according to claim 2, wherein the first silicon oxide sub-surface b protrudes relative to the second surface (32).

4. The solar cell according to claim 2, wherein a distance between the first silicon oxide sub-surface a and the first surface is 1 µm to 300 µm; and/or a distance between the first silicon oxide sub-surface b and the second surface (32) is 1 µm to 300 µm.

5. The solar cell according to claim 4, wherein a distance between the first passivation sub-surface a and the first surface is 5 µm to 250 µm; and/or a distance between the first passivation sub-surface b and the second surface is 5 µm to 250 µm.

6. The solar cell according to claim 1, wherein the N-type conductive region comprises a third surface and a fourth surface that are arranged opposite to each other, and the second silicon oxide layer comprises a second silicon oxide sub-surface a and a second silicon oxide sub-surface b that are arranged opposite to each other; and the third surface, the fourth surface, the second silicon oxide sub-surface a and the second silicon oxide sub-surface b are all perpendicular to the first direction; wherein the second silicon oxide sub-surface a is recessed relative to the third surface, and/or the second silicon oxide sub-surface b is recessed relative to the fourth surface (22).

7. The solar cell according to claim 6, whereina distance between the second silicon oxide sub-surface a and the third surface is 1 µm to 100 µm; and/or a distance between the second silicon oxide sub-surface b and the fourth surface (22) is 1 µm to 100 µm.

8. The solar cell (100) according to claim 1, wherein a surface of the P-type conductive region (3) facing away from the semiconductor substrate (1) is a smooth surface; and/or a surface of the N-type conductive region (2) facing away from the semiconductor substrate (1) is a rough surface.

9. The solar cell (100) according to claim 1, further comprising an isolation region (4) disposed between the N-type conductive region (2) and the P-type conductive region (3), wherein a first side surface (14) is a surface of the P-type conductive region (3) in contact with the isolation region (4), and the first side surface (14) is a smooth surface; and/ora second side surface (15) is a surface of the N-type conductive region (2) in contact with the isolation region (4), and the second side surface (15) is a rough surface.

10. The solar cell (100) according to claim 9, wherein a projection of the first silicon oxide layer (5) on the surface of the semiconductor substrate (1) at least partially overlaps a projection of the first side surface (14) on the surface of the semiconductor substrate (1).

11. The solar cell (100) according to claim 9 wherein an area of an overlapping area between the projection of the first silicon oxide layer (5) on the surface of the semiconductor substrate (1) and the projection of the first side surface (14) on the surface of the semiconductor substrate (1) is denoted as S1, and an area of the projection of the first side surface (14) on the surface of the semiconductor substrate (1) is denoted as S2, where S1/S2=(0.2 to 0.99):1.

12. The solar cell (100) according to claim 1, wherein an area of the projection of the second silicon oxide layer (6) on the surface of the semiconductor substrate (1) is denoted as S3, and an area of the projection of the N-type conductive region (2) on the surface of the semiconductor substrate (1) is denoted as S4, where S3/S4=(1.01 to 1.90):1.

13. The solar cell (100) according to claim 1, wherein a thickness of the first doping conductive layer (7) ranges from 50 nm to 500 nm; and/or a thickness of the second doping conductive layer (8) ranges from 50 nm to 300 nm.

14. The solar cell (100) according to claim 1, wherein a thickness of the first silicon oxide layer (5) ranges from 1 nm to 5 nm; and/or a thickness of the second silicon oxide layer (6) ranges from 1 nm to 5 nm.

15. A photovoltaic module (1000), comprising a cover plate, an encapsulation material layer, and a solar cell string, wherein the solar cell string comprises solar cells (100) according to any one of claims 1-14.
